(19) **Europäisches Patentamt**
**European Patent Office**
**Office européen des brevets**

(11) **EP 2 490 311 B1**

(12) **EUROPEAN PATENT SPECIFICATION**

(45) Date of publication and mention
of the grant of the patent:
**23.08.2017   Bulletin 2017/34**

(51) Int Cl.:
*H02H 3/40* ^(2006.01)      *G01R 31/02* ^(2006.01)

(21) Application number: **11154436.7**

(22) Date of filing: **15.02.2011**

(54) **Method and apparatus for detecting earth fault**

Verfahren und Vorrichtung zur Detektion eines Erdschlusses

Procédé et appareil pour détecter un défaut à la terre

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.08.2012   Bulletin 2012/34**

(73) Proprietor: **ABB Schweiz AG**
**5400 Baden (CH)**

(72) Inventors:
  • **Wahlroos, Ari**
    **65350, Vaasa (FI)**

  • **Altonen, Janne**
    **37800, Toijala (FI)**
  • **Hakola, Tapio**
    **65320, Vaasa (FI)**

(74) Representative: **Kolster Oy Ab**
**Salmisaarenaukio 1**
**00180 Helsinki (FI)**

(56) References cited:
    **EP-A1- 1 598 674     EP-A1- 2 192 416**

**Description**

FIELD OF THE INVENTION

The present invention relates to detecting an earth fault on a three-phase electric line of an electric network.

BACKGROUND OF THE INVENTION

The traditional and by far the most common earth fault protection functions in electricity networks are based on residual current polarized with zero-sequence voltage. Especially in unearthed and compensated distribution networks such protection functions are based on locosphi, losinphi or phase angle criterion. However, in certain countries the neutral admittance protection has become the preferred and even required earth fault protection function. Document J. Lorenc et. al, Admittance criteria for earth fault detection in substation automation systems in Polish distribution power networks, CIRED 97, Birmingham, June 1997, discloses examples of the implementation of the neutral admittance based earth fault protection.

In simple terms, the neutral admittance protection is based on evaluating the quotient: $\underline{Y}_o = \underline{I}_o/-\underline{U}_o$, i.e. neutral admittance of the network calculated from fundamental frequency phasors of residual current $\underline{I}_o$ and residual voltage $\underline{U}_o$, and comparing the result with predetermined operating boundaries (operation characteristic) in a neutral admittance domain ($\underline{Y}_o$ domain). The residual current $\underline{I}_o$ can be measured with a cable core transformer and the residual voltage $\underline{U}_o$ can be measured from open-delta connected tertiaries of single-pole isolated voltage transformers, for example.

WO2010/061055 discloses an alternative method for calculating the neutral admittance utilizing changes in the residual current and the residual voltage due to a fault:

$$\underline{Y}_o = \Delta\underline{I}_o/(-\Delta\underline{U}_o),$$

where

$$\Delta\underline{I}_o = \underline{I}_o(t_2) - \underline{I}_o(t_1)$$

$$\Delta\underline{U}_o = \underline{U}_o(t_2) - \underline{U}_o(t_1)$$

and $t_1$ and $t_2$ refer to two separate instances in time, before ($t_1$) and during ($t_2$) the fault.

In addition, WO2010/061055 discloses a neutral admittance protection characteristic, where the operation characteristic in the neutral admittance domain ($\underline{Y}_o$-domain) defines a closed area such that the centre of the closed area is offset from the origin of the admittance plane towards a negative susceptance direction and/or towards a negative conductance direction.

EP 1598674 discloses a method comprising determining network parameters including at least one network asymmetric admittance and a network zero admittance. The network parameters or the values on which these are based are stored as reference values. A determination is made for a network error admittance attributable to a possible earth fault by vector measurement of the displacement voltage on the basis of the reference values and, if the network error admittance exceeds a predetermined first amount, then an earth fault is indicated.

In the earth fault protection functions, whose operation is based on a measured neutral admittance, the operation takes place in the neutral admittance domain ($\underline{Y}_o$-domain). This means that e.g. a relay terminal with admittance protection functionality requires settings in units of the neutral admittance i.e. in Siemens or in practice in milliSiemens. Such units and the concept of the neutral admittance may not be familiar to the utility personnel using the protection equipment. Such units may be considered unpractical and difficult to understand due to the fact that they are very seldom used in the protection engineering. Because of the above reasons, extensive implementations of neutral admittance based earth fault protection may be hindered despite the possible advantages offered by the neutral admittance based earth fault protection.

BRIEF DESCRIPTION OF THE INVENTION

An object of the present invention is thus to provide a method and an apparatus for implementing the method so as to overcome the above problems or at least to alleviate them. The objects of the invention are achieved by a method, a computer program product and an apparatus which are characterized by what is stated in the independent claims. The preferred embodiments of the invention are disclosed in the dependent claims.

The invention is based on the idea of giving one or more predetermined parameter values, which define the operation characteristic of the protection, as residual current quantities, as residual power quantities, or as per unit quantities and then either converting the one or more predetermined parameter values from a residual current domain, from a residual power domain, or from a per unit domain into a neutral admittance domain or per unit domain of neutral admittance or converting a determined value of the neutral admittance from the neutral admittance domain or from the per unit domain of neutral admittance into the residual current domain, into the residual power domain, or into the per unit domain to enable the comparison of the determined value of the neutral admittance with the one or more predetermined parameter values to detect the earth fault.

An advantage of the method and arrangement of the invention is that it enables the operating boundaries to be given as residual current quantities, as residual power quantities, or as per unit quantities, while utilizing the neutral admittance based earth fault protection. Thus, the invention provides all the benefits of the neutral admittance based operation principle, e.g. immunity to a fault resistance and system unbalance, and simple settings as residual current quantities, as residual power quantities, or as per unit quantities, which are readily familiar and understandable to the utility personnel.

BRIEF DESCRIPTION OF THE DRAWINGS

In the following the invention will be described in greater detail by means of preferred embodiments with reference to the accompanying drawings, in which

Figure 1 is a simplified equivalent circuit of a three-phase electric network;
Figure 2 is a simplified equivalent circuit of a three-phase electric network;
Figure 3 shows a diagram of an embodiment;
Figure 4 shows a diagram of an embodiment;
Figure 5 shows a diagram of an embodiment;
Figure 6 shows a diagram of an embodiment;
Figure 7 shows a diagram of an embodiment;
Figure 8 shows a diagram of an embodiment;
Figure 9 shows operation characteristics on a residual current domain according to embodiments; and
Figure 10 shows operation characteristics on a residual power domain according to embodiments;
Figure 11 shows operation characteristics on a per unit domain according to embodiments; and
Figure 12 shows operation characteristics on a neutral admittance domain according to embodiments.

DETAILED DESCRIPTION OF THE INVENTION

The application of the invention is not limited to any specific system, but it can be used in connection with various three-phase electric systems to detect a phase-to-earth fault on a three-phase electric line of an electric network. The electric line can be a feeder, for example, and it may be an overhead-line or a cable or a combination of both. The electric power system in which the invention is implemented can be an electric transmission or distribution network or a component thereof, for example, and may comprise several feeders or sections. Moreover, the use of the invention is not limited to systems employing 50 Hz or 60 Hz fundamental frequencies or to any specific voltage level.

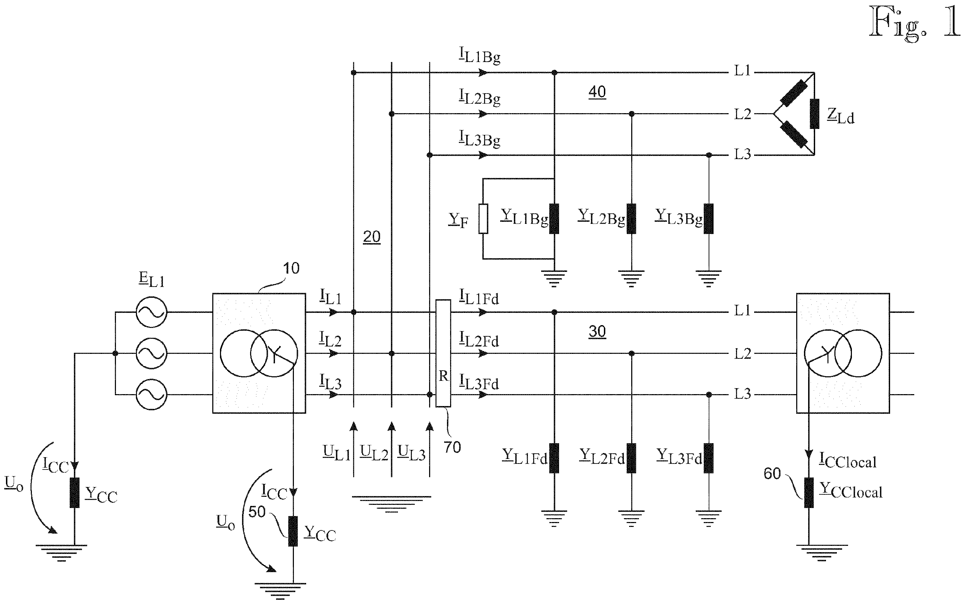

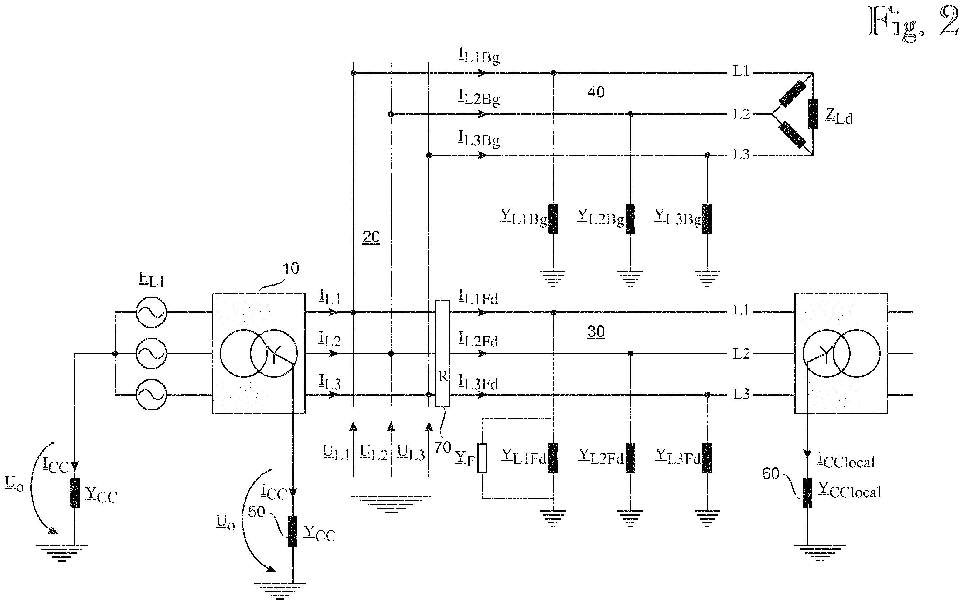

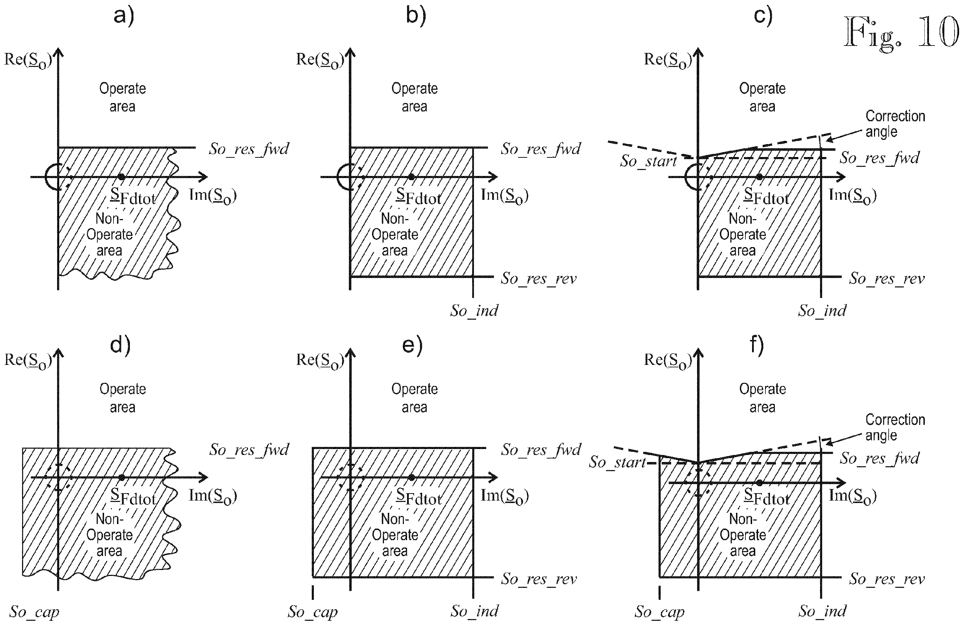

Figures 1 and 2 are examples of simplified equivalent circuits for a three-phase electric network in which the invention can be used. Figure 1 shows a situation in which there is a fault in a background network 40 and Figure 2 shows a situation in which there is a fault in the electric line 30 to be monitored. The figures show only components necessary for understanding the invention. The exemplary network can be a medium voltage (e.g. 20 kV) distribution network fed through a substation comprising a transformer 10 and a busbar 20. The illustrated network also comprises electric line outlets, i.e. feeders. Other possible feeders as well as other network parts, except the protected feeder 30, are referred to as a 'background network' and have been represented by a single line outlet 40 although it should be noted that there may be any number of feeders or other network elements in the background network. There may also be several feeding substations. Further, the invention can be utilized with a switching station without a transformer 10, for example. In case the network includes an arc-suppression coil(s), it may be located at the substation (centralized compensation 50) connected to the system neutral point directly or through an earthing transformer or at the feeders through earthing transformers (de-centralized compensation 60).

The exemplary network is a three-phase network and the three phases of the three-phase electricity system are referred to as L1, L2, and L3. In the exemplary system the functionality of the invention can be located in a relay unit 70 located at the beginning of the. It is also possible that only some measurements are performed at the location of the relay unit 70 and the results are then transmitted to another unit or units in another location for further processing. Thus, the functionality of the invention could be distributed among two or more physical units instead of just one unit and also the unit or units implementing the invention may be located in connection with the electric line 30 to be protected or possibly in a remote location. This, however, has no relevance to the basic idea of the invention. The notations used in Figures 1 and 2 are as follows:

$\underline{U}_o$ = Residual voltage of the network

$\underline{E}_{L1}$ = Phase-L1 source voltage

$\underline{Y}_{CC}$ = Admittance of the earthing arrangement 50 located at the substation. This may include a compensation coil with or without a parallel resistor, or a current limiting resistor. In case of an unearthed network $\underline{Y}_{CC}$ = 0.

$\underline{I}_{CC}$ = Current through the earthing arrangement 50 located at the substation

$\underline{I}_{L1}$ = Phase current of phase L1 measured at infeed

$\underline{I}_{L2}$ = Phase current of phase L2 measured at infeed

$\underline{I}_{L3}$ = Phase current of phase L3 measured at infeed

$\underline{I}_{L1Fd}$ = Phase current of phase L1 of the electric line

$\underline{I}_{L2Fd}$ = Phase current of phase L2 of the electric line

$\underline{I}_{L3Fd}$ = Phase current of phase L3 of the electric line

$\underline{I}_{L1Bg}$ = Phase current of phase L1 of the background network

$\underline{I}_{L2Bg}$ = Phase current of phase L2 of the background network

$\underline{I}_{L3Bg}$ = Phase current of phase L3 of the background network

$\underline{U}_{L1}$ = Phase-to-earth voltage of phase L1 at the substation

$\underline{U}_{L2}$ = Phase-to-earth voltage of phase L2 at the substation

$\underline{U}_{L3}$ = Phase-to-earth voltage of phase L3 at the substation

$\underline{Y}_F$ = Fault admittance (assumed to be pure conductance)

$\underline{Y}_{L1Fd}$ = Admittance of phase L1 of the electric line

$\underline{Y}_{L2Fd}$ = Admittance of phase L2 of the electric line

$\underline{Y}_{L3Fd}$ = Admittance of phase L3 of the electric line

$\underline{Y}_{L1Bg}$ = Admittance of phase L1 of the background network

$\underline{Y}_{L2Bg}$ = Admittance of phase L2 of the background network

$\underline{Y}_{L3Bg}$ = Admittance of phase L3 of the background network

$\underline{Z}_{Ld}$ = Phase impedance of a delta connected load

$\underline{Y}_{CClocal}$ = Admittance of the earthing arrangement 60 (a compensation coil) located at the electric line

$\underline{I}_{CClocal}$ = Current through the earthing arrangement 60 located at the electric line

Current and voltage values that are needed in the following embodiments may be obtained by a suitable measuring arrangement including e.g. current and voltage transducers (not shown in the figures) connected to the phases of the electricity system. In most of the existing protection systems, such values are readily available and thus the implementation of the various embodiments does not necessarily require any additional measuring arrangements. The residual voltage of the electric network may be determined from phase voltages or by measuring it from an open delta winding formed by voltage transformers, for example. The residual current of the electric line 30 may be determined with a suitable current measuring arrangement, such as a cable core transformer or Holmgreen connection (sum connection), at a measuring point such as the relay unit 70. How these values are obtained is of no relevance to the basic idea of the invention and depends on the particular electricity system.

According to an embodiment, a value of a neutral admittance of the three-phase electric line is determined on the basis of values of a residual voltage of the electric network and a residual current of the electric line. The neutral admittance may be calculated as the quotient between a residual current phasor $\underline{I}_o$ and a residual voltage phasor ($-\underline{U}_o$) during an earth fault:

$$\underline{Y}_o = \underline{I}_o/(-\underline{U}_o)$$

Alternatively the calculation of the neutral admittance may be done with the so-called delta quantities, where $t_1$ and $t_2$ refer to two separate instances in time, before ($t_1$) and during ($t_2$) the earth fault:

$$\underline{Y}_o = \Delta\underline{I}_o/(-\Delta\underline{U}_o),$$

where

$$\Delta \underline{I}_o = \underline{I}_o(t_2) - \underline{I}_o(t_1)$$

$$\Delta \underline{U}_o = \underline{U}_o(t_2) - \underline{U}_o(t_1)$$

The advantage of using the delta quantities is that the calculated neutral admittance becomes theoretically immune to the fault resistance and the system unbalance (under certain conditions) and can be determined by basic network data as described in the following:

With reference to Figure 1, when a single-phase earth fault occurs outside the electric line 30, the measured neutral admittance equals to the total feeder admittance (including possible de-centralized compensation coils) with a negative sign:

$$\underline{Y}_o = \Delta \underline{I}_o/(-\Delta \underline{U}_o) = -(\underline{Y}_{Fdtot} + \underline{Y}_{CClocal}),$$

where

$$\underline{Y}_{Fdtot} = \underline{Y}_{L1Fd} + \underline{Y}_{L2Fd} + \underline{Y}_{L3Fd}$$

$$\underline{Y}_{L1Fd} = G_{L1Fd} + j^*B_{L1Fd}$$

$$\underline{Y}_{L2Fd} = G_{L2Fd} + j^*B_{L2Fd}$$

$$\underline{Y}_{L3Fd} = G_{L3Fd} + j^*B_{L3Fd}$$

$G_{L1Fd}$ = Phase-to-earth conductance of phase L1 of the electric line
$G_{L2Fd}$ = Phase-to-earth conductance of phase L2 of the electric line
$G_{L3Fd}$ = Phase-to-earth conductance of phase L3 of the electric line
$B_{L1Fd}$ = Phase-to-earth susceptance of phase L1 of the electric line
$B_{L2Fd}$ = Phase-to-earth susceptance of phase L2 of the electric line
$B_{L3Fd}$ = Phase-to-earth susceptance of phase L3 of the electric line

$$\underline{Y}_{CClocal} = G_{CClocal} - j^*B_{CClocal}$$

$G_{CClocal}$ = Conductance of the earthing arrangement 60 located at the electric line 30. This includes conductance of the compensation coil(s) located on the electric line 30.
$B_{CC}$ = Susceptance of the earthing arrangement 60 located at the electric line 30. This includes susceptance of the compensation coil(s) located on the electric line 30.

With reference to Figure 2, when a single-phase earth fault occurs inside the electric line 30, the measured neutral admittance equals to the admittance of the background network 40 plus the admittance of the neutral arrangement (in case of a de-centralized compensation, the admittances of all coils outside the protected feeder can be included into admittance $\underline{Y}_{CC}$):

$$\underline{Y}_o = \Delta \underline{I}_o/(-\Delta \underline{U}_o) = \underline{Y}_{Bgtot} + \underline{Y}_{CC},$$

where

$$\underline{Y}_{Bgtot} = \underline{Y}_{L1Bg} + \underline{Y}_{L2Bg} + \underline{Y}_{L3Bg}$$

$$\underline{Y}_{L1Bg} = G_{L1Bg} + j^*B_{L1Bg}$$

$$\underline{Y}_{L2Bg} = G_{L2Bg} + j^*B_{L2Bg}$$

$$\underline{Y}_{L3Bg} = G_{L3Bg} + j^*B_{L3Bg}$$

$G_{L1Bg}$ = Phase-to-earth conductance of phase L1 of the background network
$G_{L2Bg}$ = Phase-to-earth conductance of phase L2 of the background network
$G_{L3Bg}$ = Phase-to-earth conductance of phase L3 of the background network
$B_{L1Bg}$ = Phase-to-earth susceptance of phase L1 of the background network
$B_{L2Bg}$ = Phase-to-earth susceptance of phase L2 of the background network
$B_{L3Bg}$ = Phase-to-earth susceptance of phase L3 of the background network

$$\underline{Y}_{CC} = G_{CC} - j^*B_{CC}$$

$G_{cc}$ = Conductance of the earthing arrangement 50 located at the substation. This may include the conductance of the compensation coil with or without a parallel resistor or a conductance of a current limiting resistor. In case of an unearthed network $G_{CC}$ = 0. In case of a de-centralized compensation, the conductances of all the coils outside the electric line 30 can be included into conductance $G_{CC}$.
$B_{CC}$ = Susceptance of the earthing arrangement 50 located at the substation. This may include the susceptance of the compensation coil. In case of an unearthed network $B_{CC}$ = 0. In case of a de-centralized compensation, the susceptances of all coils outside the electric line 30 can be included into susceptance $B_{CC}$.

According to an embodiment, the admittance protection, similar to other earth fault-protection functions, can use $U_o$ overvoltage condition as a common criterion for initial fault detection in the electric network. The setting value for $U_o$ start can be set above the maximum healthy $U_o$ level of the network in order to avoid false starts. According to an embodiment, when the neutral admittance is determined, the earth fault can be detected on the three-phase electric line 30 on the basis of the determined value of the neutral admittance and one or more predetermined parameter values. The predetermined parameter values define an operation characteristic on the basis of which it is possible to determine whether the earth fault is on the electric line 30 or outside it. According to an embodiment, the one or more predetermined parameter values are given as residual current quantities, as residual power quantities or as per unit quantities. According to an embodiment, the detecting of the fault comprises converting the one or more predetermined parameter values from a residual current domain, from a residual power domain, or from a per unit domain into a neutral admittance domain and comparing in the neutral admittance domain the determined value of the neutral admittance with the converted one or more predetermined parameter values. According to an alternative embodiment, the detecting of the fault comprises converting the determined value of the neutral admittance from the neutral admittance domain into the residual current domain, into the residual power domain or into the per unit domain and comparing in the residual current domain, in the residual power domain or in the per unit domain the converted value of the neutral admittance with the one or more predetermined parameter values. The earth fault can then be detected on the three-phase electric line 30 on the basis of the comparison. According to an embodiment, an earth fault is detected on the three-phase electric line 30 if the comparison shows that the determined value of the neutral admittance is within an operate area defined by the one or more predetermined parameter values. If the determined value of the neutral admittance is within a non-operate area, i.e. outside the operate area, then no earth fault is detected on the three-phase electric line 30.

According to an embodiment, the converting of the one or more predetermined parameter values from the residual current domain into the neutral admittance domain is performed according to the following equation:

$$\underline{Y}_o^* = \mathrm{conj}(\underline{I}_o)/q,$$

where

$\underline{I}_o$ = value in the residual current domain
$\underline{Y}_o^*$ = equivalent value in the neutral admittance domain

q = conversion factor.

According to an embodiment, the converting of the determined value of the neutral admittance from the neutral admittance domain into the residual current domain is performed according to the following equation:

$$\underline{I}_o{}^* = conj(\underline{Y}_o)^*q,$$

where

$\underline{Y}_o$ = value in the neutral admittance domain
$\underline{I}_o{}^*$ = equivalent value in the residual current domain
q = conversion factor.

According to an embodiment, the conversion factor q equals to a phase-to-earth voltage of the electric network. According to an embodiment, the conversion factor q equals to a nominal phase-to-earth voltage of the electric network or a measured healthy-state phase-to-earth voltage of the electric network. According to an embodiment, the conversion factor q is a scalar quantity whereby an absolute value of the phase-to-earth voltage of the electric network may be used as the conversion factor.

According to an embodiment, the converting of the one or more predetermined parameter values from the residual power domain into the neutral admittance domain is performed according to the following equation:

$$\underline{Y}_o{}^* = conj(\underline{S}_o)/q^2,$$

where

$\underline{S}_o$ = value in the residual power domain
$\underline{Y}_o{}^*$ = equivalent value in the neutral admittance domain
q = conversion factor.

According to an embodiment, the converting of the determined value of the neutral admittance from the neutral admittance domain into the residual power domain is performed according to the following equation:

$$\underline{S}_o{}^* = conj(\underline{Y}_o)^*q^2,$$

where

$\underline{Y}_o$ = value in the neutral admittance domain
$\underline{S}_o{}^*$ = equivalent value in the residual power domain
q = conversion factor.

According to an embodiment, the converting of the one or more predetermined parameter values from per unit domain of residual current or residual power into the neutral admittance domain is performed according to the following equation:

$$\underline{Y}_o{}^* = conj(\underline{pu})^*w,$$

where

$\underline{pu}$ = value in the (complex) per unit domain of residual current or residual power,
$\underline{Y}_o{}^*$ = equivalent value in the neutral admittance domain
w = conversion factor.

According to an embodiment, the converting of the determined value of the neutral admittance from the neutral admittance domain into per unit domain of residual current or residual power is performed according to the following equation:

$$\underline{pu}^*=\text{conj}(\underline{Y}_o)/w,$$

where

> $\underline{Y}_o$ = value in the neutral admittance domain
> $\underline{pu}^*$ = equivalent value in the (complex) per unit domain of residual current or residual power
> w = conversion factor.

According to an embodiment, the conversion factor w equals to a selected base value for the phase-to-earth admittance of the electric network. According to an embodiment, the conversion factor w is calculated from selected base values valid for the residual current, the residual voltage and the residual power, according to the following equation:

$$w = Y_{obase} = I_{obase}/U_{obase},$$

or

$$w = Y_{obase} = S_{obase}/U_{obase}{}^{\wedge}2$$

where

> $I_{obase}$ = selected base value valid for residual current
> $U_{obase}$ = selected base value valid for residual voltage
> $S_{obase}$ = selected base value valid for residual power.

According to an embodiment, the converting of the determined value of the neutral admittance from the per unit domain of neutral admittance into per unit domain of residual current or residual power is performed according to the following equation:

$$\underline{pu}^*=\text{conj}(Y\underline{pu}),$$

where

> $Y\underline{pu}$ = value in the (complex) per unit domain of neutral admittance,
> $\underline{pu}^*$ = equivalent value in the per unit domain of residual current or residual power

According to an embodiment, the converting of the one or more predetermined parameter values from per unit domain of residual current or residual power into the per unit domain of neutral admittance is performed according to the following equation:

$$Y\underline{pu}^*=\text{conj}(\underline{pu}),$$

where

> $\underline{pu}$ = value in the (complex) per unit domain of residual current or residual power
> $Y\underline{pu}^*$ = equivalent value in the per unit domain of neutral admittance

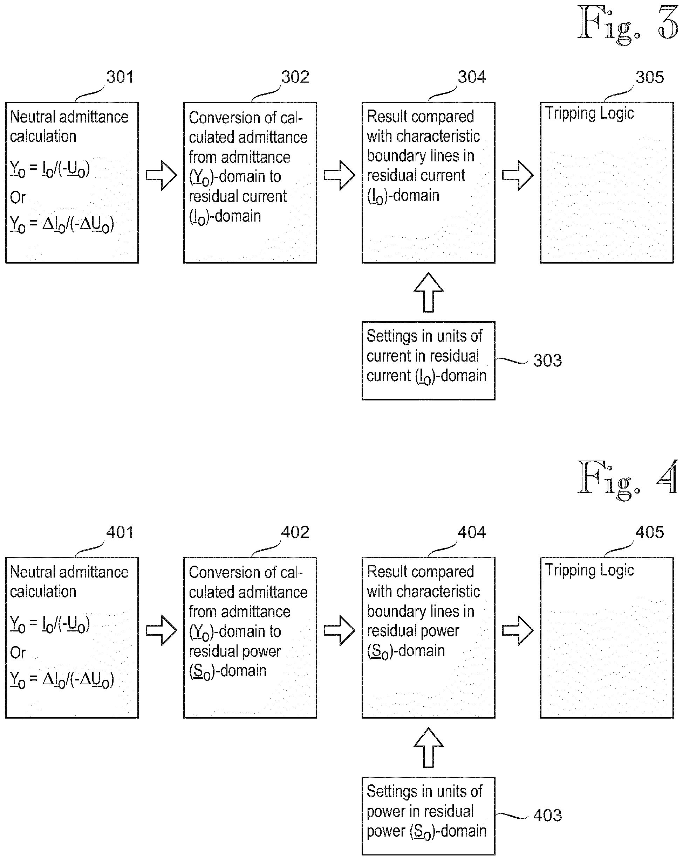

Figure 3 shows a diagram of an embodiment. In phase 301 the neutral admittance is determined. In phase 302 the determined value of the neutral admittance is converted from the neutral admittance domain into the residual current domain. In phase 304 the equivalent value of the neutral admittance in the residual current domain obtained from the conversion is compared to the predetermined parameter values (settings) given in phase 303. On the basis of the comparison 304, a tripping decision can be made in phase 305.

Figure 4 shows a diagram of an embodiment. In phase 401 the neutral admittance is determined. In phase 402 the determined value of the neutral admittance is converted from the neutral admittance domain into the residual power domain. In phase 404 the equivalent value of the neutral admittance in the residual power domain obtained from the conversion is compared to the predetermined parameter values (settings) given in phase 403. On the basis of the comparison 404, a tripping decision can be made in phase 405.

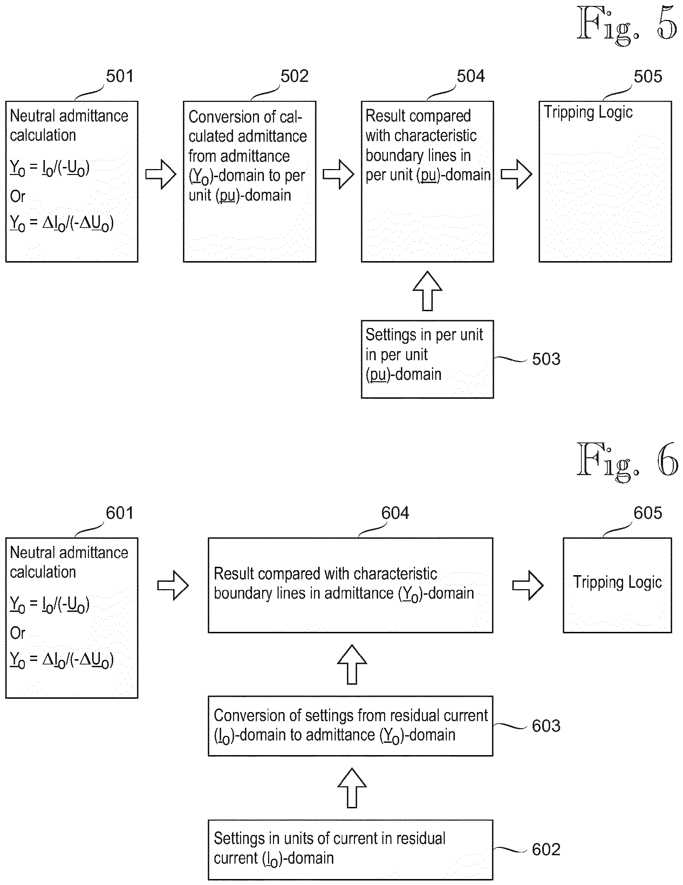

Figure 5 shows a diagram of an embodiment. In phase 501 the neutral admittance is determined. In phase 502 the determined value of the neutral admittance is converted from the neutral admittance domain into the per unit domain of residual current or residual power. In phase 504 the equivalent value of the neutral admittance in the per unit domain of residual current or residual power obtained from the conversion is compared to the predetermined parameter values (settings) given in phase 503. On the basis of the comparison 504, a tripping decision can be made in phase 505.

Figure 6 shows a diagram of another embodiment. In phase 601 the neutral admittance is determined. In phase 603 the predetermined parameter values (settings) given in phase 602 are converted from the residual current domain into the neutral admittance domain. In phase 604 the determined value of the neutral admittance is compared to the equivalent values of the predetermined parameter values in the neutral admittance domain. On the basis of the comparison 604, a tripping decision can be made in phase 605.

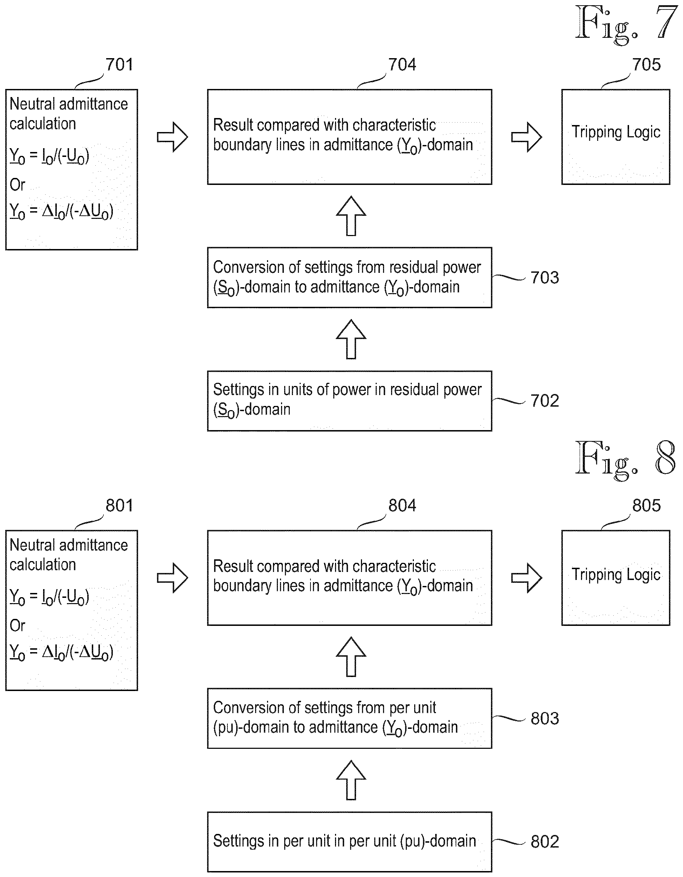

Figure 7 shows a diagram of another embodiment. In phase 701 the neutral admittance is determined. In phase 703 the predetermined parameter values (settings) given in phase 702 are converted from the residual power domain into the neutral admittance domain. In phase 704 the determined value of the neutral admittance is compared to the equivalent values of the predetermined parameter values in the neutral admittance domain. On the basis of the comparison 704, a tripping decision can be made in phase 705.

Figure 8 shows a diagram of another embodiment. In phase 801 the neutral admittance is determined. In phase 803 the predetermined parameter values (settings) given in phase 802 are converted from the per unit domain of residual current or residual power into the neutral admittance domain. In phase 804 the determined value of the neutral admittance is compared to the equivalent values of the predetermined parameter values in the neutral admittance domain. On the basis of the comparison 804, a tripping decision can be made in phase 805.

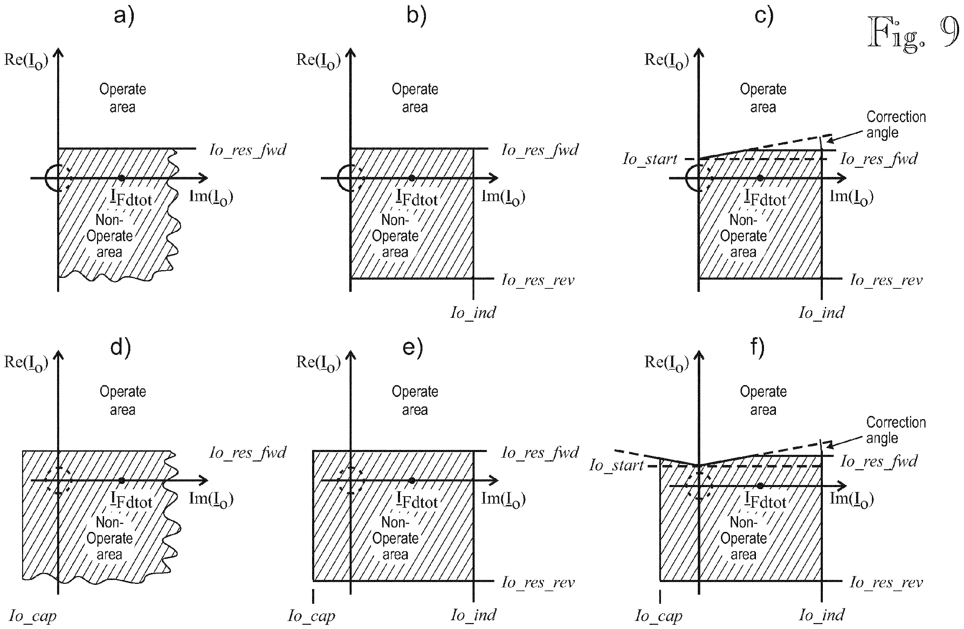

Figure 9 shows some possible operation characteristics on a residual current domain according to embodiments, which are valid for the equivalent residual current value $\underline{I}_o{}^*$ obtained from conversion of the determined neutral admittance value into the equivalent residual current value, $\underline{I}_o{}^*=\text{conj}(\underline{Y}_o)^*q$. It should be noticed that, as the measured $\underline{Y}_o$ is not affected by the fault resistance, the equivalent residual current value $\underline{I}_o{}^*$ corresponds to the physically measurable $\underline{I}_o$ only when $R_F = 0\ \Omega$. The protection characteristic representing the non-operation area, "the box", may be set around the current value corresponding to the earth fault current $\underline{I}_{Fdtot}$ produced by the electric line 30 during an outside fault. In the simplest form, only one predetermined parameter, $Io\_res\_fwd$, is required to define the operation characteristic as shown in alternative a). It may be set based on the current value corresponding to the parallel resistor of the coil and the total losses of the background network. Such a characteristic can be applied, when the earth fault current produced by the electric line 30 is unknown or it may vary greatly during the daily operation. In order to improve sensitivity, the reach may be limited with parameter $Io\_ind$. It may be set based on the earth fault current produced by the electric line 30 considering the maximum line length. The box-shaped characteristic is obtained by limiting the reach in reverse direction with parameter $Io\_res\_rev$ to the same value as $Io\_ind$ as shown in alternative b). However, the best sensitivity may be obtained by introducing a slope characteristic in forward direction with parameters *Correction angle* and $Io\_start$. The purpose of the *Correction angle* parameter is the same than in traditional earth fault protection (e.g. to compensate the measuring errors) and parameter $Io\_start$ may be set based on minimum measurable current value taking into account the practical measurement inaccuracies, see alternative c). The characteristic can be set to take into account the situation, where unwontedly the distributed coils located at the electric line 30 would overcompensate, i.e. the line would produce inductive earth fault current in case of an outside fault. Such overcompensation can be taken into account with parameter $Io\_cap$. Valid characteristics for compensated distribution networks with distributed compensation are shown in alternatives d)-f).

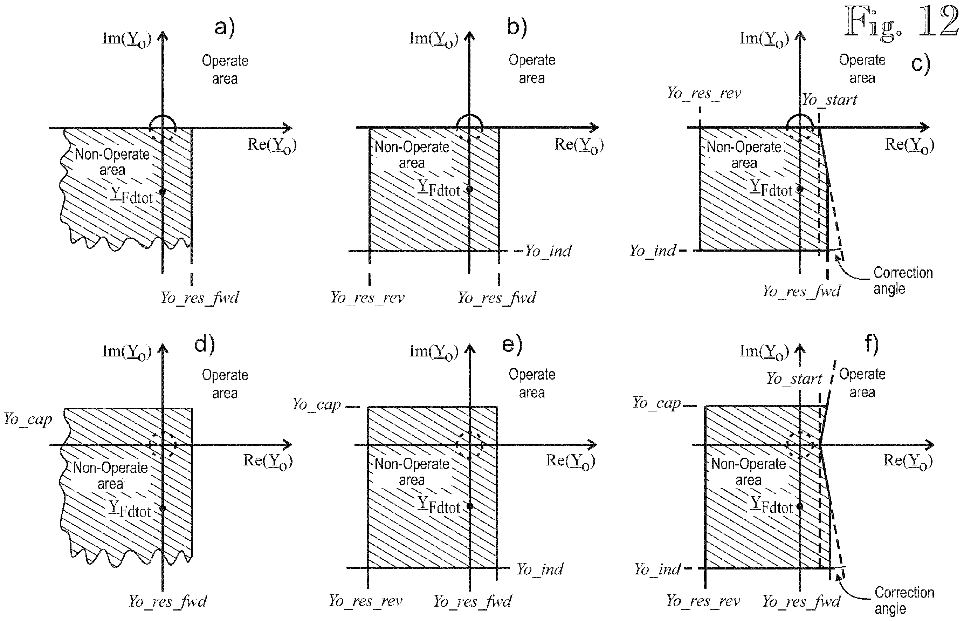

Figure 12 shows some possible operation characteristics on a neutral admittance domain according to embodiments. The alternatives a) to f) of figure 12 correspond to those of Figure 9 such that the correspondence of the parameters shown is as follows:

$$Yo\_res\_fwd \quad = conj(Io\_res\_fwd)/q \quad\quad = Io\_res\_fwd/q$$

$$Yo\_ind \quad\quad\quad = conj(+j*Io\_ind)/q \quad\quad\quad = -j*Io\_ind/q$$

$$Yo\_res\_rev = conj(Io\_res\_rev)/q = Io\_res\_rev /q$$

$$Yo\_cap = conj(-j*Io\_cap)/q = +j*Io\_cap/q$$

$$Yo\_start = conj(Io\_start)/q = Io\_start/q$$

$$\underline{Y}_{Fdtot} = conj(\underline{I}_{Fdtot})/q$$

And vica versa

$$Io\_res\_fwd = conj(Yo\_res\_fwd)*q = Yo\_res\_fwd*q$$

$$Io\_ind = conj(-j*Yo\_ind)*q = +j*Io\_ind*q$$

$$Io\_res\_rev = conj(Yo\_res\_rev)*q = Io\_res\_rev *q$$

$$Io\_cap = conj(+j*Yo\_cap)*q =- j*Io\_cap*q$$

$$Io\_start = conj(Yo\_start)*q = Io\_start*q$$

$$\underline{I}_{Fdtot} = conj(\underline{Y}_{Fdtot})*q$$

The parameters on the residual current domain can be converted into the corresponding parameters on the neutral admittance domain as described above.

Figure 10 shows some possible operation characteristics on a residual power domain according to embodiments, which are valid for the equivalent residual power value $\underline{S}_o{}^*$ obtained from conversion of the determined neutral admittance value into the equivalent residual power value, $\underline{S}_o{}^*=conj(\underline{Y}_o)*q^2$. It should be noticed that, as the measured $\underline{Y}_o$ is not affected by the fault resistance, the equivalent residual power value $\underline{S}_o{}^*$ corresponds to the physically measurable $\underline{S}_o$ only when $R_F = 0\Omega$. The protection characteristic representing the non-operation area, "the box", may be set around the power value corresponding to the earth fault power $\underline{S}_{Fdtot}$ produced by the electric line 30 during an outside fault. In the simplest form, only one predetermined parameter, *So_res_fwd*, is required to define the operation characteristic as shown in alternative a). It may be set based on the power value corresponding to the parallel resistor of the coil and the total losses of the background network. Such a characteristic can be applied, when the earth fault power produced by the electric line 30 is unknown or it may vary greatly during the daily operation. In order to improve sensitivity, the reach may be limited with parameter *So_ind.* It may be set based on the earth fault power produced by the electric line 30 considering the maximum line length. The box-shaped characteristic is obtained by limiting the reach in reverse direction with parameter *So_res_rev* to the same value as *So_ind* as shown in alternative b). However, the best sensitivity may be obtained by introducing a slope characteristic in forward direction with parameters *Correction angle* and *So_start.* The purpose of the *Correction angle* parameter is the same than in traditional earth fault protection (e.g. to compensate the measuring errors) and parameter *So_start* may be set based on minimum measurable power value taking into account the practical measurement inaccuracies, see alternative c). The characteristic can be set to take into account the situation, where unwontedly the distributed coils located at the electric line 30 would overcompensate, i.e. the line would produce inductive earth fault power in case of an outside fault. Such overcompensation can be taken into account with parameter *So_cap.* Valid characteristics for compensated distribution networks with distributed compensation are shown in alternatives d)-f).

Figure 12 shows some possible operation characteristics on a neutral admittance domain according to embodiments. The alternatives a) to f) of figure 12 correspond to those of Figure 10 such that the correspondence of the parameters shown is as follows:

$$Yo\_res\_fwd = conj(So\_res\_fwd)/q^2 = So\_res\_fwd/q^2$$

$$Yo\_ind = conj(+j*So\_ind)/q^2 = -j*So\_ind/q^2$$

$$Yo\_res\_rev = conj(So\_res\_rev)/q^2 = So\_res\_rev /q^2$$

$$Yo\_cap = conj(-j*So\_cap)/q^2 = +j*So\_cap/q^2$$

$$Yo\_start = conj(So\_start)/q^2 = So\_start/q^2$$

$$\underline{Y}_{Fdtot} = conj(\underline{S}_{Fdtot})/q^2$$

And vica versa

$$So\_res\_fwd = conj(Yo\_res\_fwd)*q^2 = Yo\_res\_fwd*q^2$$

$$So\_ind = conj(-j*Yo\_ind)*q^2 = +j*Io\_ind*q^2$$

$$So\_res\_rev = conj(Yo\_res\_rev)*q^2 = Io\_res\_rev *q^2$$

$$So\_cap = conj(+j*Yo\_cap)*q^2 =- j*Io\_cap*q^2$$

$$So\_start = conj(Yo\_start)*q^2 = Io\_start*q^2$$

$$\underline{S}_{Fdtot} = conj(\underline{Y}_{Fdtot})*q^2$$

The parameters on the residual power domain can be converted into the corresponding parameters on the neutral admittance domain as described above.

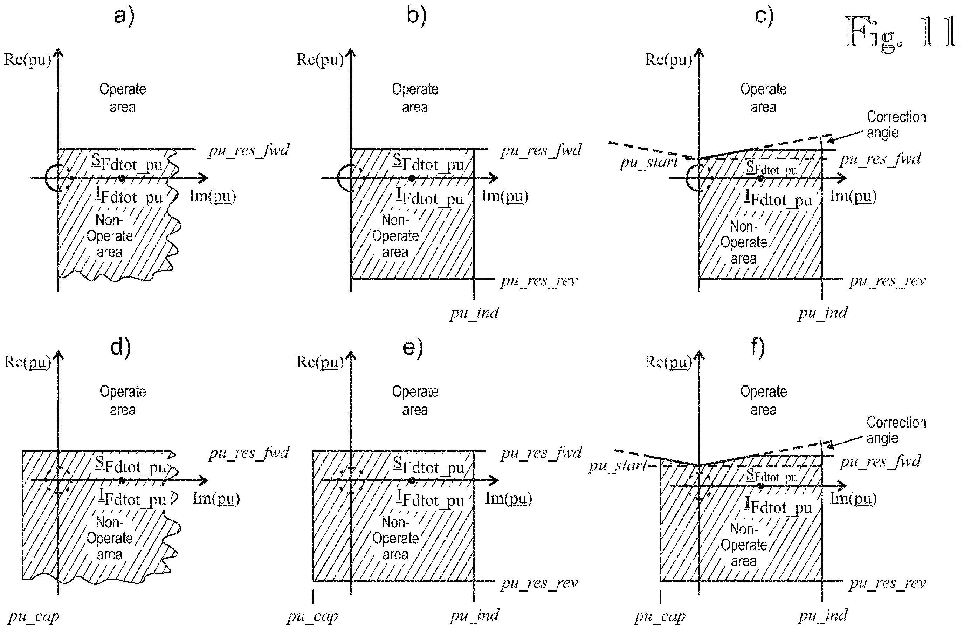

Figure 11 shows some possible operation characteristics on a per unit domain of residual current or residual power according to embodiments, which are valid for the equivalent per unit value $\underline{pu}^*$ obtained from conversion of the determined neutral admittance value into the equivalent per unit value, $\underline{pu}^*=conj(\underline{Y}_o)/w$. The protection characteristic representing the non-operation area, "the box", may be set around the per unit current value corresponding to the earth fault current $I_{Fdtot\_pu}$ or power $S_{Fdtot\_pu}$ produced by the electric line 30 during an outside fault. In the simplest form, only one predetermined parameter, $pu\_res\_fwd$, is required to define the operation characteristic as shown in alternative a). It may be set based on the per unit current or power value corresponding to the parallel resistor of the coil and the total losses of the background network. Such a characteristic can be applied, when the earth fault current produced by the electric line 30 is unknown or it may vary greatly during the daily operation. In order to improve sensitivity, the reach may be limited with parameter $pu\_ind$. It may be set based on the per unit earth fault current or power produced by the electric line 30 considering the maximum line length. The box-shaped characteristic is obtained by limiting the reach in reverse direction with parameter $pu\_res\_rev$ to the same value as $pu\_ind$ as shown in alternative b). However, the best sensitivity may be obtained by introducing a slope characteristic in forward direction with parameters *Correction angle* and $pu\_start$. The purpose of the *Correction angle* parameter is the same than in traditional earth fault protection (e.g.

to compensate the measuring errors) and parameter *pu_start* may be set based on minimum measurable per unit current (or power) value taking into account the practical measurement inaccuracies, see alternative c). The characteristic can be set to take into account the situation, where unwontedly the distributed coils located at the electric line 30 would overcompensate, i.e. the line would produce inductive earth fault current (or power) in case of an outside fault. Such overcompensation can be taken into account with parameter *pu_cap*. Valid characteristics for compensated distribution networks with distributed compensation are shown in alternatives d)-f).

Figure 12 shows some possible operation characteristics on the neutral admittance domain according to embodiments. The alternatives a) to f) of figure 12 correspond to those of Figure 11 such that the correspondence of the parameters shown is as follows:

$$Yo\_res\_fwd = conj(pu\_res\_fwd)*w = pu\_res\_fwd*w$$

$$Yo\_ind = conj(+j* pu\_ind)*w = -j* pu\_ind*w$$

$$Yo\_res\_rev = conj(pu\_res\_rev)*w = pu\_res\_rev*w$$

$$Yo\_cap = conj(-j* pu\_cap)*w = +j* pu\_cap*w$$

$$Yo\_start = conj(pu\_start)*w = pu\_start*w$$

$$\underline{Y}_{Fdtot} = conj(\underline{I}_{Fdtot\_pu})*w$$

$$\underline{Y}_{Fdtot} = conj(\underline{S}_{Fdtot\_pu})*w$$

And vica versa

$$pu\_res\_fwd = conj(Yo\_res\_fwd)/w = Yo\_res\_fwd/w$$

$$pu\_ind = conj(-j*Yo\_ind)/w = +j*Io\_ind/w$$

$$pu\_res\_rev = conj(Yo\_res\_rev)/w = Io\_res\_rev/w$$

$$pu\_cap = conj(+j*Yo\_cap)/w = -j*Io\_cap/w$$

$$pu\_start = conj(Yo\_start)/w = Io\_start/w$$

$$\underline{I}_{Fdtot\_pu} = conj(\underline{Y}_{Fdtot})/w$$

$$\underline{S}_{Fdtot\_pu} = conj(\underline{Y}_{Fdtot})/w$$

The parameters on the per unit domain can be converted into the corresponding parameters on the neutral admittance domain as described above.

An apparatus according to any one of the above embodiments, or a combination thereof, may be implemented as a single unit or as two or more separate units that are configured to implement the functionality of the various embodiments. Here the term 'unit' refers generally to a physical or logical entity, such as a physical device or a part thereof or a software routine. One or more of these units may reside in the protective relay unit 70, for example.

An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of the microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, and output means for outputting e.g. calculation results and/or control data. It is also possible to use a specific integrated circuit or circuits, or corresponding components and devices for implementing the functionality according to any one of the embodiments.

The invention can be implemented in existing system elements, such as various protective relays or relay arrangements, or by using separate dedicated elements or devices in a centralized or distributed manner. Present protective devices for electric systems, such as protective relays, typically comprise processors and memory that can be utilized in the functions according to embodiments of the invention. Thus, all modifications and configurations required for implementing an embodiment of the invention e.g. in existing protective devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory means, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but by the scope of the claims.

**Claims**

1. A method for detecting an earth fault on a three-phase electric line of an electric network, the method comprising:

   determining (301; 401; 501; 601; 701; 801) a value of a neutral admittance of the three-phase electric line (30) on the basis of values of a residual voltage of the electric network and a residual current of the electric line; detecting the earth fault on the three-phase electric line (30) on the basis of the determined value of the neutral admittance and one or more predetermined parameter values, **characterized in that** the one or more predetermined parameter values are given as residual current quantities, as residual power quantities, or as per unit quantities, and **in that** the detecting of the fault on the three-phase electric line (30) comprises:

   a) converting (603; 703; 803) the one or more predetermined parameter values from a residual current domain, from a residual power domain, or from a per unit domain into a neutral admittance domain or into a per unit domain of neutral admittance; and comparing (604; 704; 804) in the neutral admittance domain or in the per unit domain of neutral admittance the determined value of the neutral admittance with the converted one or more predetermined parameter values;
   or
   b) converting (302; 402; 502) the determined value of the neutral admittance from a neutral admittance domain or from a per unit domain of neutral admittance into a residual current domain, into a residual power domain, or into a per unit domain; and comparing (304; 404; 504) in the residual current domain, in the residual power domain, or in the per unit domain the converted value of the neutral admittance with the one or more predetermined parameter values;

and

c) detecting (305; 405; 505; 605; 705; 805) the earth fault on the basis of the comparison.

2. A method as claimed in claim 1, wherein, as per alternative a), the converting (603) of the one or more predetermined parameter values from the residual current domain into the neutral admittance domain is performed according to the following equation:

$$\underline{Y}_o{}^* = \operatorname{conj}(\underline{I}_o)/q,$$

where

$\underline{I}_o$ = value in the residual current domain
$\underline{Y}_o{}^*$ = equivalent value in the neutral admittance domain
$q$ = conversion factor.

3. A method as claimed in claim 1 or 2, wherein, as per alternative b), the converting (302) of the determined value of the neutral admittance from the neutral admittance domain into the residual current domain is performed according to the following equation:

$$\underline{I}_o{}^* = \operatorname{conj}(\underline{Y}_o){}^*q,$$

where

$\underline{Y}_o$ = value in the neutral admittance domain
$\underline{I}_o{}^*$ = equivalent value in the residual current domain
$q$ = conversion factor.

4. A method as claimed in claim 1, 2 or 3, wherein, as per alternative a), the converting (703) of the one or more predetermined parameter values from the residual power domain into the neutral admittance domain is performed according to the following equation:

$$\underline{Y}_o{}^* = \operatorname{conj}(\underline{S}_o)/q^{\wedge}2,$$

where

$\underline{S}_o$ = value in the residual power domain
$\underline{Y}_o{}^*$ = equivalent value in the neutral admittance domain
$q$ = conversion factor.

5. A method as claimed in any one of claims 1 to 4, wherein, as per alternative b), the converting (402) of the determined value of the neutral admittance from the neutral admittance domain into the residual power domain is performed according to the following equation:

$$\underline{S}_o{}^* = \operatorname{conj}(\underline{Y}_o){}^*q^{\wedge}2,$$

where

$\underline{Y}_o$ = value in the neutral admittance domain
$\underline{S}_o{}^*$ = equivalent value in the residual power domain
$q$ = conversion factor.

6. A method as claimed in any one of claims 2 to 5, wherein the conversion factor q equals to a phase-to-earth voltage of the electric network.

7. A method as claimed in any one of claims 1 to 6, wherein, as per alternative a), the converting (803) of the one or more predetermined parameter values from a per unit domain of residual current or residual power into the neutral admittance domain is performed according to the following equation:

$$\underline{Y}_o{}^*=conj(\underline{pu})^*w,$$

where

$\underline{pu}$ = value in the (complex) per unit domain of residual current or residual power,
$\underline{Y}_o{}^*$ = equivalent value in the neutral admittance domain
w = conversion factor.

8. A method as claimed in any one of claims 1 to 7, wherein, as per alternative b), the converting (502) of the determined value of the neutral admittance from the neutral admittance domain into a per unit domain of residual current or residual power is performed according to the following equation:

$$\underline{pu}^*=conj(\underline{Y}_o)/w,$$

where

$\underline{Y}_o$ = value in the neutral admittance domain
$\underline{pu}^*$ = equivalent value in the (complex) per unit domain of residual current or residual power
w = conversion factor.

9. A computer program product comprising computer program code, wherein execution of the program code in a computer causes the computer to carry out all the steps of the method according to any one of claims 1 to 8.

10. An apparatus for detecting an earth fault on a three-phase electric line of an electric network, the apparatus comprising:

means (70) adapted for determining a value of a neutral admittance of the three-phase electric line (30) on the basis of values of a residual voltage of the electric network and a residual current of the electric line;
means (70) adapted for detecting the earth fault on the three-phase electric line (30) on the basis of the determined value of the neutral admittance and one or more predetermined parameter values, **characterized in that** the one or more predetermined parameter values are residual current quantities, residual power quantities, or per unit quantities, and **in that** the means (70) adapted for detecting the fault on the three-phase electric line (30) comprises:

a) means adapted for converting the one or more predetermined parameter values from a residual current domain, from a residual power domain, or from a per unit domain into a neutral admittance domain or into a per unit domain of neutral admittance; and means adapted for comparing in the neutral admittance domain or in the per unit domain of neutral admittance the value of the neutral admittance with the converted one or more predetermined parameter values;
or
b) means adapted for converting the determined value of the neutral admittance from a neutral admittance domain or from a per unit domain of neutral admittance into a residual current domain, into a residual power domain, or into a per unit domain; and means adapted for comparing in the residual current domain, in the residual power domain, or in the per unit domain the converted value of the neutral admittance with the one or more predetermined parameter values;
and
c) means adapted for detecting the earth fault on the basis of the

11. An apparatus as claimed in claim 10, wherein, as per alternative a), the means adapted for converting the one or more predetermined parameter values from the residual current domain into the neutral admittance domain are configured to perform the conversion according to the following equation:

$$\underline{Y}_o{}^* = \text{conj}(\underline{I}_o)/q,$$

where

$\underline{I}_o$ = value in the residual current domain
$\underline{Y}_o{}^*$ = equivalent value in the neutral admittance domain
q = conversion factor.

12. An apparatus as claimed in claim 10 or 11, wherein, as per alternative b), the means adapted for converting the determined value of the neutral admittance from the neutral admittance domain into the residual current domain are configured to perform the conversion according to the following equation:

$$\underline{I}_o{}^* = \text{conj}(\underline{Y}_o)^*q,$$

where

$\underline{Y}_o$ = value in the neutral admittance domain
$\underline{I}_o{}^*$ = equivalent value in the residual current domain
q = conversion factor.

13. An apparatus as claimed in claim 10, 11 or 12, wherein, as per alternative a), the means adapted for converting the one or more predetermined parameter values from the residual power domain into the neutral admittance domain are configured to perform the conversion according to the following equation:

$$\underline{Y}_o{}^* = \text{conj}(\underline{S}_o)/q^2,$$

where

$\underline{S}_o$ = value in the residual power domain
$\underline{Y}_o{}^*$ = equivalent value in the neutral admittance domain
q = conversion factor.

14. An apparatus as claimed any one of claims 10 to 13, wherein, as per alternative b), the means adapted for converting the determined value of the neutral admittance from the neutral admittance domain into the residual power domain are configured to perform the conversion according to the following equation:

$$\underline{S}_o{}^* = \text{conj}(\underline{Y}_o)^*q^2,$$

where

$\underline{Y}_o$ = value in the neutral admittance domain
$\underline{S}_o{}^*$ = equivalent value in the residual power domain
q = conversion factor.

15. An apparatus as claimed in any one of claims 11 or 14, wherein the conversion factor q equals to a earth voltage of the electric network.

16. An apparatus as claimed any one of claims 10 to 15, wherein, as per alternative a), the means adapted for converting the one or more predetermined parameter values from a per unit domain of residual current or residual power into the neutral admittance domain are configured to perform the conversion according to the following equation:

$$\underline{Y}_o{}^* = \text{conj}(\underline{pu})^*w,$$

where

pu = value in the (complex) per unit domain of residual current or residual power,
$\underline{Y}_o^*$ = equivalent value in the neutral admittance domain
w = conversion factor.

17. An apparatus as claimed any one of claims 10 to 16, wherein, as per alternative b), the means adapted for converting the determined value of the neutral admittance from the neutral admittance domain into a per unit domain of residual current or residual power are configured to perform the conversion according to the following equation:

$$\underline{pu}^*=conj(\underline{Y}_o)/w,$$

where

$\underline{Y}_o$ = value in the neutral admittance domain
$\underline{pu}^*$ = equivalent value in the (complex) per unit domain of residual current or residual power
w = conversion factor.

**Patentansprüche**

1. Verfahren zum Detektieren eines Erdschlusses auf einer dreiphasigen elektrischen Leitung eines elektrischen Netzwerks, wobei das Verfahren umfasst:

Bestimmen (301; 401; 501; 601; 701; 801) eines Wertes einer Neutraladmittanz der dreiphasigen elektrischen Leitung (30) auf der Basis von Werten einer Restspannung des elektrischen Netzwerks und eines Reststroms der elektrischen Leitung;
Detektieren des Erdschlusses auf der dreiphasigen elektrischen Leitung (30) auf der Basis des bestimmten Wertes der Neutraladmittanz und eines oder mehrerer vorgegebener Parameterwerte, **dadurch gekennzeichnet, dass** der eine oder die mehreren vorgegebenen Parameterwerte als Reststromgrößen, als Restleistungsgrößen oder als Größen pro Einheit gegeben sind und dadurch, dass das Detektieren des Erdschlusses auf der dreiphasigen elektrischen Leitung (30) umfasst:

a) Umwandeln (603; 703; 803) des einen oder der mehreren vorgegebenen Parameterwerte von einem Reststrombereich, von einem Restleistungsbereich oder von einem Pro-Einheit-Bereich in einen Neutraladmittanzbereich oder in einen Neutraladmittanz-pro-Einheit-Bereich; und Vergleichen (604; 704; 804), in dem Neutraladmittanzbereich oder in dem Neutraladmittanz-pro-Einheit-Bereich, des bestimmten Wertes der Neutraladmittanz mit dem umgewandelten einen oder den umgewandelten mehreren vorgegebenen Parameterwerten;
oder
b) Umwandeln (302; 402; 502) des bestimmten Wertes der Neutraladmittanz von einem Neutraladmittanzbereich oder von einem Neutraladmittanz-pro-Einheit-Bereich in einen Reststrombereich, in einen Restleistungsbereich oder in einen Pro-Einheit-Bereich; und Vergleichen (304; 404; 504), in dem Reststrombereich, in dem Restleistungsbereich oder in dem Pro-Einheit-Bereich, des umgewandelten Wertes der Neutraladmittanz mit dem einen oder den mehreren vorgegebenen Parameterwerten;
und
c) Detektieren (305; 405; 505; 605; 705; 805) des Erdschlusses auf der Basis des Vergleichs.

2. Verfahren nach Anspruch 1, bei dem, gemäß Alternative a), das Umwandeln (603) des einen oder der mehreren vorgegebenen Parameterwerte von dem Reststrombereich in den Neutraladmittanzbereich gemäß der folgenden Gleichung durchgeführt wird:

$$\underline{Y}_o^*=conj(\underline{I}_o)/q,$$

mit

$I_o$ = Wert in dem Reststrombereich
$Y_o^*$ = äquivalenter Wert in dem Neutraladmittanzbereich
q = Umwandlungsfaktor.

3. Verfahren nach Anspruch 1 oder 2, bei dem, gemäß Alternative b), das Umwandeln (302) des bestimmten Wertes der Neutraladmittanz von dem Neutraladmittanzbereich in den Reststrombereich gemäß der folgenden Gleichung durchgeführt wird:

$$I_o^* = \text{conj}(Y_o) * q,$$

mit

$Y_o$ = Wert in dem Neutraladmittanzbereich
$I_o^*$ = äquivalenter Wert in dem Reststrombereich
q = Umwandlungsfaktor.

4. Verfahren nach Anspruch 1, 2 oder 3, bei dem, gemäß Alternative a), das Umwandeln (703) des einen oder der mehreren vorgegebenen Parameterwerte von dem Restleistungsbereich in den Neutraladmittanzbereich gemäß der folgenden Gleichung durchgeführt wird:

$$Y_o^* = \text{conj}(S_o)/q^2,$$

mit

$S_o$ = Wert in dem Restleistungsbereich
$Y_o^*$ = äquivalenter Wert in dem Neutraladmittanzbereich
q = Umwandlungsfaktor.

5. Verfahren nach einem der Ansprüche 1 bis 4, bei dem, gemäß Alternative b), das Umwandeln (402) des bestimmten Wertes der Neutraladmittanz von dem Neutraladmittanzbereich in den Restleistungsbereich gemäß der folgenden Gleichung durchgeführt wird:

$$S_o^* = \text{conj}(Y_o) * q^2,$$

mit

$Y_o$ = Wert in dem Neutraladmittanzbereich
$S_o^*$ = äquivalenter Wert in dem Restleistungsbereich
q = Umwandlungsfaktor.

6. Verfahren nach einem der Ansprüche 2 bis 5, wobei der Umwandlungsfaktor q gleich einer Phase-zu-Erde-Spannung des elektrischen Netzwerks ist.

7. Verfahren nach einem der Ansprüche 1 bis 6, bei dem, gemäß Alternative a), das Umwandeln (803) des einen oder der mehreren vorgegebenen Parameterwerte von einem Reststrom-pro-Einheit-Bereich oder Restleistung-pro-Einheit-Bereich in den Neutraladmittanzbereich gemäß der folgenden Gleichung durchgeführt wird:

$$Y_o^* = \text{conj}(pu) * w,$$

mit

pu = Wert in dem (komplexen) Reststrom-pro-Einheit-Bereich oder Restleistung-pro-Einheit-Bereich,
$Y_o^*$ = äquivalenter Wert in dem Neutraladmittanzbereich

w = Umwandlungsfaktor.

8. Verfahren nach einem der Ansprüche 1 bis 7, bei dem, gemäß Alternative b), das Umwandeln (502) des bestimmten Wertes der Neutraladmittanz von dem Neutraladmittanzbereich in einen Reststrom-pro-Einheit-Bereich oder Restleistung-pro-Einheit-Bereich gemäß der folgenden Gleichung durchgeführt wird:

$$\underline{pu}^* = conj(\underline{Y}_o)/w,$$

mit

$\underline{Y}_o$ = Wert in dem Neutraladmittanzbereich
$\underline{pu}^*$ = äquivalenter Wert in dem (komplexen) Reststrom-pro-Einheit-Bereich oder Restleistung-pro-Einheit-Bereich
w = Umwandlungsfaktor.

9. Computerprogrammprodukt mit einem Computerprogrammcode, wobei die Ausführung des Programmcodes in einem Computer den Computer veranlasst, alle Schritte des Verfahrens gemäß einem der Ansprüche 1 bis 8 auszuführen.

10. Vorrichtung zum Detektieren eines Erdschlusses auf einer dreiphasigen elektrischen Leitung eines elektrischen Netzwerks, wobei die Vorrichtung aufweist:

Mittel (70), die dazu eingerichtet sind, einen Wert einer Neutraladmittanz der dreiphasigen elektrischen Leitung (30) auf der Basis von Werten einer Restspannung des elektrischen Netzwerks und eines Reststroms der elektrischen Leitung zu bestimmen;
Mittel (70), die dazu eingerichtet sind, den Erdschluss auf der dreiphasigen elektrischen Leitung (30) auf der Basis des bestimmten Wertes der Neutraladmittanz und eines oder mehrerer vorgegebener Parameterwerte zu detektieren,
**dadurch gekennzeichnet, dass** der eine oder die mehreren vorgegebenen Parameterwerte Reststromgrößen, Restleistungsgrößen oder Größen pro Einheit sind und dass die Mittel (70), die dazu eingerichtet sind, den Erdschlusses auf der dreiphasigen elektrischen Leitung (30) zu detektieren, umfassen:

a) Mittel, die dazu eingerichtet sind, den einen oder die mehreren vorgegebenen Parameterwerte von einem Reststrombereich, von einem Restleistungsbereich oder von einem Pro-Einheit-Bereich in einen Neutraladmittanzbereich oder in einen Neutraladmittanz-pro-Einheit-Bereich umzuwandeln; und Mittel, die dazu eingerichtet sind, in dem Neutraladmittanzbereich oder in dem Neutraladmittanz-pro-Einheit-Bereich den Wert der Neutraladmittanz mit dem umgewandelten einen oder den umgewandelten mehreren vorgegebenen Parameterwerten zu vergleichen;
oder
b) Mittel, die dazu eingerichtet sind, den bestimmten Wert der Neutraladmittanz von einem Neutraladmittanzbereich oder von einem Neutraladmittanz-pro-Einheit-Bereich in einen Reststrombereich, in einen Restleistungsbereich oder in einen Pro-Einheit-Bereich umzuwandeln; und Mittel, die dazu eingerichtet sind, in dem Reststrombereich, in dem Restleistungsbereich oder in dem Pro-Einheit-Bereich den umgewandelten Wert der Neutraladmittanz mit dem einen oder den mehreren vorgegebenen Parameterwerten zu vergleichen;
und
c) Mittel, die dazu eingerichtet sind, den Erdschluss auf der Basis des Vergleichs zu detektieren.

11. Vorrichtung nach Anspruch 10, bei der, gemäß Alternative a), die Mittel, die dazu eingerichtet sind, den einen oder die mehreren vorgegebenen Parameterwerte von dem Reststrombereich in den Neutraladmittanzbereich umzuwandeln, dazu eingerichtet sind, die Umwandlung gemäß der folgenden Gleichung durchzuführen:

$$\underline{Y}_o^* = conj(\underline{I}_o)/q,$$

mit

$\underline{I}_o$ = Wert in dem Reststrombereich
$\underline{Y}_o$* = äquivalenter Wert in dem Neutraladmittanzbereich
q = Umwandlungsfaktor.

**12.** Vorrichtung nach Anspruch 10 oder 11, bei der, gemäß Alternative b), die Mittel, die dazu eingerichtet sind, den bestimmten Wertes der Neutraladmittanz von dem Neutraladmittanzbereich in den Reststrombereich umzuwandeln, dazu eingerichtet sind, die Umwandlung gemäß der folgenden Gleichung durchzuführen:

$$\underline{I}_o*=conj(\underline{Y}_o)*q,$$

mit

$\underline{Y}_o$ = Wert in dem Neutraladmittanzbereich
$\underline{I}_o$* = äquivalenter Wert in dem Reststrombereich
q = Umwandlungsfaktor.

**13.** Vorrichtung nach Anspruch 10, 11 oder 12, bei der, gemäß Alternative a), die Mittel, die dazu eingerichtet sind, den einen oder die mehreren vorgegebenen Parameterwerte von dem Restleistungsbereich in den Neutraladmittanzbereich umzuwandeln, dazu eingerichtet sind, die Umwandlung gemäß der folgenden Gleichung durchzuführen:

$$\underline{Y}_o*=conj(\underline{S}_o)/q^2,$$

mit

$\underline{S}_o$ = Wert in dem Restleistungsbereich
$\underline{Y}_o$* = äquivalenter Wert in dem Neutraladmittanzbereich
q = Umwandlungsfaktor.

**14.** Vorrichtung nach einem der Ansprüche 10 bis 13, bei der, gemäß Alternative b), die Mittel, die dazu eingerichtet sind, den bestimmten Wert der Neutraladmittanz von dem Neutraladmittanzbereich in den Restleistungsbereich umzuwandeln, dazu eingerichtet sind, die Umwandlung gemäß der folgenden Gleichung durchzuführen:

$$\underline{S}_o*=conj(\underline{Y}_o)*q^2,$$

mit

$\underline{Y}_o$ = Wert in dem Neutraladmittanzbereich
$\underline{S}_o$* = äquivalenter Wert in dem Restleistungsbereich
q = Umwandlungsfaktor.

**15.** Vorrichtung nach Anspruch 11 oder 14, wobei der Umwandlungsfaktor q gleich einer Phase-zu-Erde-Spannung des elektrischen Netzwerks ist.

**16.** Vorrichtung nach einem der Ansprüche 10 bis 15, bei der, gemäß Alternative a), die Mittel, die dazu eingerichtet sind, den einen oder die mehreren vorgegebenen Parameterwerte von einem Reststrom-pro-Einheit-Bereich oder einem Restleistung-pro-Einheit-Bereich in den Neutraladmittanzbereich umzuwandeln, dazu eingerichtet sind, die Umwandlung gemäß der folgenden Gleichung durchzuführen:

$$\underline{Y}_o*=conj(\underline{pu})*w,$$

mit

$\underline{pu}$ = Wert in dem (komplexen) Reststrom-pro-Einheit-Bereich oder Restleistung-pro-Einheit-Bereich,

$\underline{Y}_o^*$ = äquivalenter Wert in dem Neutraladmittanzbereich
w = Umwandlungsfaktor.

**17.** Vorrichtung nach einem der Ansprüche 10 bis 16, bei der, gemäß Alternative b), die Mittel, die dazu eingerichtet sind, den bestimmten Wert der Neutraladmittanz von dem Neutraladmittanzbereich in einen Reststrom-pro-Einheit-Bereich oder einen Restleistung-pro-Einheit-Bereich umzuwandeln, dazu eingerichtet sind, die Umwandlung gemäß der folgenden Gleichung durchzuführen:

$$\underline{pu}^* = conj(\underline{Y}_o)/w,$$

mit

$\underline{Y}_o$ = Wert in dem Neutraladmittanzbereich
$\underline{pu}^*$ = äquivalenter Wert in dem (komplexen) Reststrom-pro-Einheit-Bereich oder Restleistung-pro-Einheit-Bereich
w = Umwandlungsfaktor.

## Revendications

**1.** Méthode de détection d'un défaut à la terre sur une ligne électrique triphasée d'un réseau électrique, la méthode comprenant :

la détermination (301 ; 401 ; 501 ; 601 ; 701 ; 801) d'une valeur d'une admittance neutre de la ligne électrique triphasée (30) sur la base de valeurs d'une tension résiduelle du réseau électrique et d'un courant résiduel de la ligne électrique ;
la détection du défaut à la terre sur la ligne électrique triphasée (30) sur la base de la valeur déterminée de l'admittance neutre et d'une ou de plusieurs valeurs de paramètre prédéterminées, **caractérisé en ce que** les une ou plusieurs valeurs de paramètre prédéterminées sont données sous la forme de quantité de courant résiduel, sous la forme de quantité de puissance résiduelle, ou sous la forme de quantités par unité, et **en ce que** la détection du défaut sur la ligne électrique triphasée (30) comprend :

a) la conversion (603 ; 703 ; 803) des une ou plusieurs valeurs de paramètre prédéterminées à partir d'un domaine de courant résiduel, à partir d'un domaine de puissance résiduelle, ou à partir d'un domaine par unité dans un domaine d'admittance neutre ou dans un domaine par unité d'admittance neutre ; et la comparaison (604 ; 704 ; 804) dans le domaine d'admittance neutre ou dans le domaine par unité d'admittance neutre de la valeur déterminée de l'admittance neutre aux une ou plusieurs valeurs de paramètre prédéterminées converties ;
ou
b) la conversion (302 ; 402 ; 502) de la valeur déterminée de l'admittance neutre à partir d'un domaine d'admittance neutre ou à partir d'un domaine par unité d'admittance neutre dans un domaine de courant résiduel, dans un domaine de puissance résiduelle, ou dans un domaine par unité ; et la comparaison (304 ; 404 ; 504) dans le domaine de courant résiduel, dans le domaine de puissance résiduelle, ou dans le domaine par unité de la valeur convertie de l'admittance neutre aux une ou plusieurs valeurs de paramètre prédéterminées ;
et
c) la détection (305 ; 405 ; 505 ; 605 ; 705 ; 805) du défaut à la terre sur la base de la comparaison.

**2.** Méthode selon la revendication 1, dans laquelle, selon la variante a), la conversion (603) des une ou plusieurs valeurs de paramètre prédéterminées à partir du domaine de courant résiduel dans le domaine d'admittance neutre est réalisée selon l'équation suivante :

$$\underline{Y}_o^* = conj(\underline{I}_o)/q,$$

où

$\underline{I}_o$ = valeur dans le domaine de courant résiduel
$\underline{Y}_o^*$ = valeur équivalente dans le domaine d'admittance neutre
q = facteur de conversion.

3. Méthode selon la revendication 1 ou 2, dans laquelle, selon la variante b), la conversion (302) de la valeur déterminée de l'admittance neutre à partir du domaine d'admittance neutre dans le domaine de courant résiduel est réalisée selon l'équation suivante :

$$\underline{I}_o^* = \text{conj}(\underline{Y}_o) * q,$$

où

$\underline{Y}_o$ = valeur dans le domaine d'admittance neutre
$\underline{I}_o^*$ = valeur équivalente dans le domaine de courant résiduel
q = facteur de conversion.

4. Méthode selon la revendication 1, 2 ou 3, dans laquelle, selon la variante a), la conversion (703) des une ou plusieurs valeurs de paramètre prédéterminées à partir du domaine de puissance résiduelle dans le domaine d'admittance neutre est réalisée selon l'équation suivante :

$$\underline{Y}_o^* = \text{conj}(\underline{S}_o)/q^2,$$

où

$\underline{S}_o$ = valeur dans le domaine de puissance résiduelle
$\underline{Y}_o^*$ = valeur équivalente dans le domaine d'admittance neutre
q = facteur de conversion.

5. Méthode selon l'une quelconque des revendications 1 à 4, dans laquelle, selon la variante b), la conversion (402) de la valeur déterminée de l'admittance neutre à partir du domaine d'admittance neutre dans le domaine de puissance résiduelle est réalisée selon l'équation suivante :

$$\underline{S}_o^* = \text{conj}(\underline{Y}_o) * q^2,$$

où

$\underline{Y}_o$ = valeur dans le domaine d'admittance neutre
$\underline{S}_o^*$ = valeur équivalente dans le domaine de puissance résiduelle
q = facteur de conversion.

6. Méthode selon l'une quelconque des revendications 2 à 5, dans laquelle le facteur de conversion q est égal à une tension phase-terre du réseau électrique.

7. Méthode selon l'une quelconque des revendications 1 à 6, dans laquelle, selon la variante a), la conversion (803) des une ou plusieurs valeurs de paramètre prédéterminées à partir d'un domaine par unité de courant résiduel ou de puissance résiduelle dans le domaine d'admittance neutre est réalisée selon l'équation suivante :

$$\underline{Y}_o^* = \text{conj}(\underline{pu}) * w,$$

où

$\underline{pu}$ = valeur dans le domaine (complexe) par unité de courant résiduel ou de puissance résiduelle,
$\underline{Y}_o^*$ = valeur équivalente dans le domaine d'admittance neutre

w = facteur de conversion.

8. Méthode selon l'une quelconque des revendications 1 à 7, dans laquelle, selon la variante b), la conversion (502) de la valeur déterminée de l'admittance neutre à partir du domaine d'admittance neutre dans un domaine par unité de courant résiduel ou de puissance résiduelle est réalisée selon l'équation suivante :

$$\underline{pu}^{*} = \mathrm{conj}(\underline{Y}_{o})/w,$$

où

$\underline{Y}_{o}$ = valeur dans le domaine d'admittance neutre
$\underline{pu}^{*}$ = valeur équivalente dans le domaine (complexe) par unité de courant résiduel ou de puissance résiduelle,
w = facteur de conversion.

9. Produit de programme informatique comprenant un code de programme informatique, dans lequel l'exécution du code de programme par un ordinateur amène l'ordinateur à effectuer toutes les étapes de la méthode selon l'une quelconque des revendications 1 à 8.

10. Appareil de détection d'un défaut à la terre sur une ligne électrique triphasée d'un réseau électrique, l'appareil comprenant :

un moyen (70) adapté pour déterminer une valeur d'une admittance neutre de la ligne électrique triphasée (30) sur la base de valeurs d'une tension résiduelle du réseau électrique et d'un courant résiduel de la ligne électrique ;
un moyen (70) adapté pour détecter le défaut à la terre sur la ligne électrique triphasée (30) sur la base de la valeur déterminée de l'admittance neutre et d'une ou de plusieurs valeurs de paramètre prédéterminées, **caractérisé en ce que** les une ou plusieurs valeurs de paramètre prédéterminées sont des quantités de courant résiduel, des quantités de puissance résiduelle, ou des quantités par unité, et **en ce que** le moyen (70) conçu pour détecter le défaut sur la ligne électrique triphasée (30) comprend :

a) un moyen adapté pour convertir les une ou plusieurs valeurs de paramètre prédéterminées à partir d'un domaine de courant résiduel, à partir d'un domaine de puissance résiduelle, ou à partir d'un domaine par unité dans un domaine d'admittance neutre ou dans un domaine par unité d'admittance neutre ; et un moyen conçu pour comparer dans le domaine d'admittance neutre ou dans le domaine par unité d'admittance neutre la valeur de l'admittance neutre aux une ou plusieurs valeurs de paramètre prédéterminées converties ;
ou
b) un moyen adapté pour convertir la valeur déterminée de l'admittance neutre à partir d'un domaine d'admittance neutre ou à partir d'un domaine par unité d'admittance neutre dans un domaine de courant résiduel, dans un domaine de puissance résiduelle, ou dans un domaine par unité ; et un moyen conçu pour comparer dans le domaine de courant résiduel, dans le domaine de puissance résiduelle, ou dans le domaine par unité la valeur convertie de l'admittance neutre aux une ou plusieurs valeurs de paramètre prédéterminées ;
et
c) un moyen adapté pour détecter le défaut à la terre sur la base de la comparaison.

11. Appareil selon la revendication 10, dans lequel, selon la variante a), les moyens adaptés pour convertir les une ou plusieurs valeurs de paramètre prédéterminées à partir du domaine de courant résiduel dans le domaine d'admittance neutre sont adaptés pour effectuer la conversion selon l'équation suivante :

$$\underline{Y}_{o}^{*} = \mathrm{conj}(\underline{I}_{o})/q,$$

où

$\underline{I}_{o}$ = valeur dans le domaine de courant résiduel
$\underline{Y}_{o}^{*}$ = valeur équivalente dans le domaine d'admittance neutre

q = facteur de conversion.

**12.** Appareil selon la revendication 10 ou 11, dans lequel, selon la variante b), les moyens adaptés pour convertir la valeur déterminée de l'admittance neutre à partir du domaine d'admittance neutre dans le domaine de courant résiduel sont adaptés pour effectuer la conversion selon l'équation suivante :

$$\underline{I}_0{}^* = \text{conj}(\underline{Y}_0){}^*q,$$

où

  $\underline{Y}_0$ = valeur dans le domaine d'admittance neutre
  $\underline{I}_0{}^*$ = valeur équivalente dans le domaine de courant résiduel
  q = facteur de conversion.

**13.** Appareil selon la revendication 10, 11 ou 12, dans lequel, selon la variante a), les moyens adaptés pour convertir les une ou plusieurs valeurs de paramètre prédéterminées à partir du domaine de puissance résiduelle dans le domaine d'admittance neutre sont adaptés pour effectuer la conversion selon l'équation suivante :

$$\underline{Y}_0{}^* = \text{conj}(\underline{S}_0)/q{}^\wedge 2,$$

où

  $\underline{S}_0$ = valeur dans le domaine de puissance résiduelle
  $\underline{Y}_0{}^*$ = valeur équivalente dans le domaine d'admittance neutre
  q = facteur de conversion.

**14.** Appareil selon l'une quelconque des revendications 10 à 13, dans lequel, selon la variante b), les moyens adaptés pour convertir la valeur déterminée de l'admittance neutre à partir du domaine d'admittance neutre dans le domaine de puissance résiduelle sont adaptés pour effectuer la conversion selon l'équation suivante :

$$\underline{S}_0{}^* = \text{conj}(\underline{Y}_0){}^*q{}^\wedge 2,$$

où

  $\underline{Y}_0$ = valeur dans le domaine d'admittance neutre
  $\underline{S}_0{}^*$ = valeur équivalente dans le domaine de puissance résiduelle
  q = facteur de conversion.

**15.** Appareil selon l'une quelconque des revendications 11 ou 14, dans lequel le facteur de conversion q est égal à une tension phase-terre du réseau électrique.

**16.** Appareil selon l'une quelconque des revendications 10 à 15, dans lequel, selon la variante a), les moyens adaptés pour convertir les une ou plusieurs valeurs de paramètre prédéterminées à partir du domaine par unité de courant résiduel ou de puissance résiduelle dans le domaine d'admittance neutre sont adaptés pour effectuer la conversion selon l'équation suivante :

$$\underline{Y}_0{}^* = \text{conj}(\underline{pu}){}^*w,$$

où

  $\underline{pu}$ = valeur dans le domaine (complexe) par unité de courant résiduel ou de puissance résiduelle,
  $\underline{Y}_0{}^*$ = valeur équivalente dans le domaine d'admittance neutre
  w = facteur de conversion.

**17.** Appareil selon l'une quelconque des revendications 10 à 16, dans lequel, selon la variante b), les moyens adaptés pour convertir la valeur déterminée de l'admittance neutre à partir du domaine d'admittance neutre dans le domaine par unité de courant résiduel ou de puissance résiduelle sont adaptés pour effectuer la conversion selon l'équation suivante :

$$\underline{pu}^* = \text{conj}(\underline{Y}_\circ)/w,$$

où

$\underline{Y}_\circ$ = valeur dans le domaine d'admittance neutre
$\underline{pu}^*$ = valeur équivalente dans le domaine (complexe) par unité de courant résiduel ou de puissance résiduelle,
$w$ = facteur de conversion.

Fig. 1

EP 2 490 311 B1

**Fig. 2**

Fig. 3

| 301 | | 302 | | 304 | | 305 |
|-----|-----|-----|-----|-----|-----|-----|
| Neutral admittance calculation $\underline{Y}_0 = \underline{I}_0/(-\underline{U}_0)$ Or $\underline{Y}_0 = \Delta\underline{I}_0/(-\Delta\underline{U}_0)$ | ⇨ | Conversion of cal-culated admittance from admittance $(\underline{Y}_0)$-domain to residual current $(\underline{I}_0)$-domain | ⇨ | Result compared with characteristic boundary lines in residual current $(\underline{I}_0)$-domain | ⇨ | Tripping Logic |

⇧

Settings in units of current in residual current $(\underline{I}_0)$-domain ⌐ 303

Fig. 4

| 401 | | 402 | | 404 | | 405 |
|-----|-----|-----|-----|-----|-----|-----|
| Neutral admittance calculation $\underline{Y}_0 = \underline{I}_0/(-\underline{U}_0)$ Or $\underline{Y}_0 = \Delta\underline{I}_0/(-\Delta\underline{U}_0)$ | ⇨ | Conversion of cal-culated admittance from admittance $(\underline{Y}_0)$-domain to residual power $(\underline{S}_0)$-domain | ⇨ | Result compared with characteristic boundary lines in residual power $(\underline{S}_0)$-domain | ⇨ | Tripping Logic |

⇧

Settings in units of power in residual power $(\underline{S}_0)$-domain ⌐ 403

Fig. 5

| 501 | 502 | 504 | 505 |
|---|---|---|---|
| Neutral admittance calculation<br><br>$\underline{Y}_0 = \underline{I}_0/(-\underline{U}_0)$<br><br>Or<br><br>$\underline{Y}_0 = \Delta\underline{I}_0/(-\Delta\underline{U}_0)$ | Conversion of calculated admittance from admittance $(\underline{Y}_0)$-domain to per unit (pu)-domain | Result compared with characteristic boundary lines in per unit (pu)-domain | Tripping Logic |

Settings in per unit in per unit (pu)-domain — 503

Fig. 6

| 601 | 604 | 605 |
|---|---|---|
| Neutral admittance calculation<br><br>$\underline{Y}_0 = \underline{I}_0/(-\underline{U}_0)$<br><br>Or<br><br>$\underline{Y}_0 = \Delta\underline{I}_0/(-\Delta\underline{U}_0)$ | Result compared with characteristic boundary lines in admittance $(\underline{Y}_0)$-domain | Tripping Logic |

Conversion of settings from residual current $(\underline{I}_0)$-domain to admittance $(\underline{Y}_0)$-domain — 603

Settings in units of current in residual current $(\underline{I}_0)$-domain — 602

$$\text{Fig. 7}$$

701

Neutral admittance calculation

$\underline{Y}_0 = \underline{I}_0/(-\underline{U}_0)$

Or

$\underline{Y}_0 = \Delta\underline{I}_0/(-\Delta\underline{U}_0)$

⇒

704

Result compared with characteristic boundary lines in admittance ($\underline{Y}_0$)-domain

⇒

705

Tripping Logic

⇑

703

Conversion of settings from residual power ($\underline{S}_0$)-domain to admittance ($\underline{Y}_0$)-domain

⇑

702

Settings in units of power in residual power ($\underline{S}_0$)-domain

$$\text{Fig. 8}$$

801

Neutral admittance calculation

$\underline{Y}_0 = \underline{I}_0/(-\underline{U}_0)$

Or

$\underline{Y}_0 = \Delta\underline{I}_0/(-\Delta\underline{U}_0)$

⇒

804

Result compared with characteristic boundary lines in admittance ($\underline{Y}_0$)-domain

⇒

805

Tripping Logic

⇑

803

Conversion of settings from per unit (pu)-domain to admittance ($\underline{Y}_0$)-domain

⇑

802

Settings in per unit in per unit (pu)-domain

a)

Re($\underline{I}_O$)

Operate area

Io_res_fwd

Im($\underline{I}_O$)

$\underline{I}_{Fdtot}$

Non-Operate area

b)

Re($\underline{I}_O$)

Operate area

Io_res_fwd

Im($\underline{I}_O$)

$\underline{I}_{Fdtot}$

Non-Operate area

Io_res_rev

Io_ind

c)

Re($\underline{I}_O$)

Operate area

Correction angle

Io_start

Io_res_fwd

Im($\underline{I}_O$)

$\underline{I}_{Fdtot}$

Non-Operate area

Io_res_rev

Io_ind

d)

Re($\underline{I}_O$)

Operate area

Io_res_fwd

Im($\underline{I}_O$)

$\underline{I}_{Fdtot}$

Non-Operate area

Io_cap

e)

Re($\underline{I}_O$)

Operate area

Io_res_fwd

Im($\underline{I}_O$)

$\underline{I}_{Fdtot}$

Non-Operate area

Io_res_rev

Io_cap

Io_ind

f)

Re($\underline{I}_O$)

Operate area

Correction angle

Io_start

Io_res_fwd

Im($\underline{I}_O$)

$\underline{I}_{Fdtot}$

Non-Operate area

Io_res_rev

Io_cap

Io_ind

Fig. 9

EP 2 490 311 B1

Fig. 10

EP 2 490 311 B1

Fig. 11

EP 2 490 311 B1

Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010061055 A

- EP 1598674 A